# FASCICULE DE BREVET EUROPEEN

(11) **EP 2 842 155 B1**
(45) Date de publication et mention de la délivrance du brevet: **06.12.2017**
(21) Numéro de dépôt: 13727372.8
(22) Date de dépôt: 24.04.2013
(51) Int. Cl.: H01L 25/065, H01L 23/00, H01L 21/302, H01L 21/762, H01L 21/20, H01L 21/18

(54) **PROCEDE DE COLLAGE DANS UNE ATMOSPHERE DE GAZ PRESENTANT UN COEFFICIENT DE JOULE-THOMSON NEGATIF**
BINDUNGSVERFAHREN IN DER ATMOSPHÄRE EINES GASES MIT EINEM NEGATIVEN JOULE-THOMSON-KOEFFIZIENTEN
PROCESS FOR BONDING IN AN ATMOSPHERE OF A GAS HAVING A NEGATIVE JOULE-THOMSON COEFFICIENT

(30) Priorité: 27.04.2012 FR 1253921
(43) Date de publication de la demande: 04.03.2015
(73) Titulaire: Commissariat à l'Énergie Atomique et aux Énergies Alternatives, 75015 Paris (FR)
(72) Inventeur: RIEUTORD, François, F-38120 Saint Egrève (FR)
(74) Mandataire: Nony
(86) Numéro de dépôt international: PCT/IB2013/053229
(87) Numéro de publication internationale: WO 2013/160841

(56) Documents cités:
- EP-A1- 2 200 077
- EP-A1- 2 442 353
- JP-A- 2007 194 343

## Description

La présente invention concerne le domaine du collage direct. Elle a plus particulièrement pour objet un nouveau procédé de collage par adhésion moléculaire de deux substrats.

Le collage direct de matériaux (« wafer bonding » ou « direct bonding » en langue anglaise), encore improprement appelé « collage moléculaire », est une technique bien connue pour réaliser des assemblages de matériaux, notamment dans le domaine de la microélectronique. Le collage direct intervient en particulier dans les techniques de réalisation de structures semi-conducteurs multicouches (également dénommées « structures composites » ou « multilayer semiconductor wafers » en langue anglaise), comme par exemple dans les techniques de type Smart Cut®, qui mettent en oeuvre le transfert d'une couche mince d'un substrat donneur sur un substrat de réception, ladite couche mince étant rendue solidaire du substrat de réception par adhésion moléculaire.

D'une manière générale, le collage direct est initié par application locale d'une légère pression mécanique sur les substrats mis en contact. Cette pression a pour objet d'amener les deux matériaux à une distance suffisamment faible pour que les forces d'attraction (force de Van der Waals, liaisons hydrogène, voire liaisons covalentes) entre atomes ou molécules des deux surfaces à coller puissent s'établir. Une onde de collage se propage alors à partir du point d'initiation sur toute l'étendue des surfaces, avec pour effet de coller intimement les deux substrats. L'application d'un point de pression n'est cependant pas obligatoire. Le simple fait de mettre en contact deux surfaces suffisamment planes peut suffire à initier spontanément, au bout d'un temps plus ou moins long, la propagation de l'onde de collage.

L'étude de cette onde de collage et des paramètres qui déterminent sa vitesse est notamment exposée dans la publication Rieutord et al., Dynamics of a bonding front, Physical Review Letters, vol. 94, pp. 236101, 2005. Il y est mentionné que l'avancée de l'onde est le résultat de deux effets antagonistes : d'une part, l'énergie d'adhésion des plaques qui tend à propager la zone collée et, d'autre part, la résistance visqueuse du gaz piégé entre les plaques qui tend à freiner cette extension.

Pour exploiter les structures multicouches formées par collage direct, notamment dans le domaine de la microélectronique, il est indispensable d'obtenir une interface de collage présentant une qualité et une homogénéité excellentes. En effet, le collage de deux plaques de matériaux par adhésion moléculaire est généralement suivi d'une ou plusieurs étapes d'amincissement de l'une des plaques collées, par exemple par polissage mécano-chimique, attaque chimique ou rupture, pour ne laisser qu'un film mince (typiquement de quelques micromètres à quelques dizaines de nanomètres), si bien que la surface exposée du film mince final va se trouver très proche de l'interface de collage.

Dès lors, si certaines zones sont mal collées, la couche finale peut être arrachée au cours des différentes étapes technologiques qui suivent le collage (amincissement, recuit, réalisation de composant, etc.).

Malheureusement, le collage par adhésion moléculaire entraîne généralement l'apparition de défauts, notamment de type « bulles » et de type « picots » en bordure des substrats collés. Par « bulles », on entend des défauts qui résultent du piégeage de gaz et/ou d'eau à l'interface de collage entre les deux substrats. Par « picots », on entend des défauts qui résultent du collage et qui sont typiquement observés à la périphérie de la structure finale (généralement sous la forme d'une plaquette circulaire). De tels défauts sont également connus sous la dénomination anglo-saxonne « edge voids ». Ces défauts sont généralement observés à l'opposé du point d'initiation sur un secteur qui peut être relativement large (120° typiquement) et, dans le cas où l'initiation est effectuée au centre des plaques, sur l'ensemble de la périphérie des plaques.

La présence de telles particules ou bulles piégées à l'interface de collage, agissant comme espaceurs entre les surfaces collées, est susceptible d'affecter la qualité du collage des deux substrats et s'avère donc particulièrement dommageable pour les applications visées des structures collées par adhésion moléculaire.

Qui plus est, dans le cadre de la mise en oeuvre de techniques de transfert de couche mince de type Smart Cut®, il a été observé que l'apparition des défauts picots est accentuée dans le cas de la réalisation du collage d'un substrat donneur recyclé (c'est-à-dire un substrat donneur ayant déjà servi pour le prélèvement et le transfert d'une couche mince, plaquette dite « refresh »), par rapport à la réalisation du collage d'un substrat donneur originel (n'ayant jamais servi au prélèvement et au transfert d'une couche mince, plaquette dite « fresh »). La présence accrue de défauts fait ainsi obstacle à la mise en oeuvre de plaques recyclées dans les techniques de transfert de couche mince.

Différentes voies ont été explorées pour tenter de diminuer le nombre ou la taille de ces défauts.

Par exemple, la vitesse de l'onde de collage a été identifiée comme étant un facteur influençant le nombre de défauts, avec un effet bénéfique de la réduction de cette vitesse sur le nombre de défauts. A cet effet, différentes techniques de contrôle de cette vitesse ont été proposées, notamment *via* un traitement de l'état de surface de l'un et/ou l'autre desdits substrats, en particulier par chauffage (WO 2007060145). Il a également été proposé, en vue de réduire la vitesse de l'onde de collage, de projeter, au moment du collage, un jet gazeux, éventuellement chaud, en direction du point d'initiation de l'onde de collage (EP 2 963 157). Toutefois, ces traitements, s'ils peuvent effectivement induire une réduction de la vitesse de collage, sont susceptibles de réduire également l'énergie d'adhésion, ce qui peut être préjudiciable pour certaines applications. La relation entre vitesse de l'onde de collage et énergie d'adhésion est par exemple décrite par Rieutord et al. (Dynamics of a bonding front, Physical Review Letters, vol. 94, pp. 236101, 2005).

Egalement, le document EP 2 200 077 propose d'opérer la mise en contact intime des substrats sous vide partiel, en vue de diminuer le nombre de défauts sans affecter de façon notable l'énergie d'adhésion. Cette méthode de collage sous vide partiel rend toutefois difficilement utilisable les équipements classiques pour le collage par adhésion moléculaire de fixation et d'alignement des substrats.

Enfin, on peut encore citer le document EP 1 566 830 qui propose de modifier la configuration des bords de plaques lors de leur fabrication, en particulier de modifier la courbure des tombées de bord. Cette solution présente toutefois l'inconvénient de nécessiter une intervention mécanique préalable sur les plaques à coller.

Le document JP 2007 194343 décrit le collage de deux substrats dans une atmosphère d'eau et d'hydrogène/hélium. Après le collage, un traitement thermique est effectué afin de réduire les défauts de types "*voids*" à l'interface de collage entre les substrats. La présente invention vise à proposer un nouveau moyen pour réduire le nombre de défauts occasionnés lors du collage direct, voire même d'éviter totalement la formation de tels défauts.

Plus précisément, les inventeurs ont découvert qu'il est possible de réduire ces défauts, voire de les éliminer totalement, en opérant le collage par adhésion moléculaire des substrats dans une atmosphère spécifique de gaz présentant, à la température et à la pression de ladite atmosphère, un coefficient de Joule-Thomson négatif.

Ainsi, la présente invention concerne, selon un premier de ses aspects, un procédé de collage par adhésion moléculaire de deux substrats, comprenant au moins :
(a) la mise en contact intime des surfaces à coller desdits substrats ;
(b) la propagation d'une onde de collage entre lesdits substrats ;
caractérisé en ce que lesdits substrats sont maintenus au cours de l'étape (b) dans une atmosphère de gaz présentant, à la température et à la pression de ladite atmosphère, un coefficient de Joule-Thomson négatif.

Bien entendu, il appartient à l'homme du métier de mettre en oeuvre les deux substrats juxtaposés de l'étape (a) dans des conditions propices à la propagation de l'onde de collage.

Il peut s'agir, par exemple, de maintenir en contact les deux surfaces à coller pendant une durée suffisante longue pour initier spontanément le processus de collage.

Selon une variante de réalisation particulièrement avantageuse, la propagation de l'onde de collage en étape (b) peut être initiée par l'application d'au moins un point de pression sur au moins l'une des faces externes de l'ensemble formé par les deux substrats juxtaposés. L'application d'une force de contact permet avantageusement de déclencher rapidement le processus de collage entre les deux substrats.

Le procédé de l'invention peut être plus particulièrement mis en oeuvre dans une enceinte fermée contenant l'atmosphère de gaz requise selon l'invention.

Selon un mode de réalisation particulier, les étapes (a) et (b) sont toutes les deux opérées dans une atmosphère de gaz conforme à l'invention, en particulier à l'aide d'un dispositif classique de collage direct introduit dans une enceinte contenant ladite atmosphère de gaz.

Par « mise en contact intime », on entend signifier que les surfaces à coller sont amenées à une distance suffisamment faible pour permettre d'initier le collage, typiquement à une distance inférieure à quelques nanomètres.

Par « point de pression », encore appelé « point de contact », on entend désigner l'application locale d'une force de contact sur la surface exposée d'au moins l'un des substrats accolés, par exemple au moyen d'un outil d'application (« doigt métallique » ou encore « bond pin » en langue anglaise). Comme précisé précédemment, le point de pression est tel qu'il génère une onde de collage qui va se propager à partir du point de pression. Cette propagation sera par exemple concentrique dans le cas où le point de pression est exercé dans la zone centrale des deux surfaces juxtaposées.

Par « onde de collage », on entend désigner le front de liaison ou d'adhésion moléculaire qui se propage à partir d'un point d'initiation du collage et qui correspond à la diffusion des forces attractives (forces de Van Der Waals par exemple) depuis ce point d'initiation sur toute l'étendue de la surface de contact intime entre les deux substrats.

Sauf mention contraire, il est fait état dans la suite du texte des « surfaces à coller », également appelées « première surface de collage » et « seconde surface de collage », pour désigner chacune des surfaces des deux substrats, amenées au contact l'une de l'autre pour le collage.

Le procédé de l'invention s'avère avantageux à plusieurs titres.

Tout d'abord, comme illustré dans l'exemple qui suit, la mise en oeuvre d'une atmosphère de gaz selon l'invention lors du collage par adhésion moléculaire permet de s'affranchir de l'apparition de défauts picots ou de bulles en bordure des substrats collés.

Par ailleurs, l'utilisation d'une telle atmosphère de gaz n'affecte pas l'efficacité du collage, en particulier n'impacte pas l'énergie d'adhésion. Ceci est particulièrement avantageux dans le cas de l'assemblage de plaques sur lesquelles des circuits sont déjà implémentés et qui ne peuvent pas être soumis à un recuit ultérieur à haute température en vue d'augmenter, après collage, l'énergie d'adhésion.

Egalement, le procédé de l'invention, ne nécessitant qu'une adaptation de l'atmosphère lors du collage, il n'impacte pas les étapes de préparation des échantillons, ce qui permet ainsi d'optimiser séparément et sans interaction les processus de traitement de surface pour permettre par exemple d'accroître l'énergie d'adhésion requise par l'application visée.

Enfin, le procédé de l'invention s'avère particulièrement aisé à mettre en oeuvre, dans la mesure où les équipements, classiquement employés pour le collage par adhésion moléculaire de substrats, peuvent être utilisés. En particulier, le collage selon l'invention peut être effectué dans une atmosphère à pression atmosphérique et à température ambiante, ce qui autorise l'utilisation de systèmes de fixation des substrats basés sur une dépression sous le support, et de permettre de maintenir opérationnels nombre de systèmes d'alignement et de contrôle généralement mis en oeuvre dans les machines de collage.

Comme développé par la suite, le procédé de collage de l'invention peut être mis en oeuvre dans le cadre de la réalisation de structures diverses où le collage direct de surfaces est souhaité, et en particulier dans les techniques de formation de structures comportant une couche mince en un matériau semi-conducteur sur un substrat de réception, à l'image de la technique Smart Cut® qui sera détaillée dans la suite du texte.

Ainsi, selon un autre de ses aspects, la présente invention concerne un procédé de formation d'une structure comportant une couche mince (13) en un matériau semi-conducteur, en particulier en silicium, sur un substrat, comprenant au moins les étapes consistant en :
(c) disposer d'un substrat donneur (A) comportant une partie à transférer comprenant au moins une couche mince (13) dudit matériau semi-conducteur et présentant une première surface de collage (15), et d'un substrat de réception (B) présentant une seconde surface de collage (15') ;
(d) coller par adhésion moléculaire ladite première surface (15) et ladite seconde surface (15') ; et
(e) éliminer le reste du substrat donneur (A) de ladite partie collée audit substrat de réception (B),
caractérisé en ce que l'étape (d) est effectuée selon un procédé de collage tel que défini précédemment.

D'autres caractéristiques, variantes et applications du procédé selon l'invention ressortiront mieux à la lecture de la description, des exemples et figures qui vont suivre, donnés à titre illustratif et non limitatif

Sauf indication contraire, l'expression « comportant/comprenant un(e) » doit être comprise comme « comportant/comprenant au moins un(e) ».

### ATMOSPHERE DE GAZ

Comme évoqué précédemment, le collage des substrats selon l'invention est opéré dans une atmosphère de gaz présentant, à la température et à la pression de ladite atmosphère, un coefficient de Joule-Thomson négatif, en particulier inférieur ou égal à - 0,01 K/bar, notamment inférieur ou égal à - 0,05 K/bar.

Le coefficient de Joule-Thomson décrit, pour un gaz ou mélange de gaz donné, la variation de température associée à un changement de pression µ_{JT}=ΔT/ΔP lorsque le volume du gaz ou mélange de gaz augmente (le gaz subit une détente).

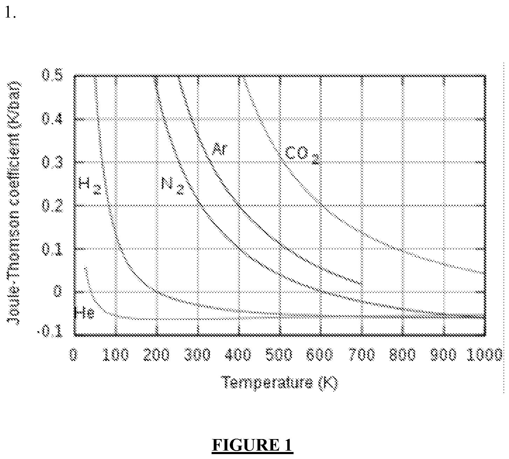

La figure 1 présente à titre d'exemple les courbes de variation du coefficient de Joule-Thomson en fonction de la température pour différents gaz à pression atmosphérique. Il peut être par exemple observé sur ce graphe qu'à température ambiante et pression atmosphérique, l'hélium et l'hydrogène présentent un coefficient de Joule-Thomson négatif, ce qui signifie qu'à température ambiante et pression atmosphérique, ces gaz s'échaufferont au cours d'une détente.

Par « atmosphère de gaz », on entend signifier que ladite atmosphère est formée d'un gaz ou mélange de gaz.

La composition d'une atmosphère conforme à l'invention est telle que dans les conditions de température et de pression données, ladite atmosphère présente un coefficient de Joule-Thomson négatif L'homme du métier est à même de choisir la nature du ou desdits gaz, d'ajuster la température et la pression de mise en oeuvre, pour former une atmosphère conforme à l'invention.

Plus particulièrement, l'atmosphère selon l'invention comprend un ou plusieurs gaz présentant, à la température et pression données, un coefficient de Joule-Thomson négatif.

Selon un mode de réalisation particulièrement préféré, le collage est opéré à température ambiante et pression atmosphérique.

Par « température ambiante », on entend signifier une température d'environ 25 °C. Par «pression atmosphérique », on entend signifier une pression d'environ 1013 hPa.

Dans le cadre de ce mode de réalisation, ladite atmosphère peut comprendre un ou plusieurs gaz choisi(s) parmi l'hélium, le néon et l'hydrogène.

Selon une première variante de réalisation, ladite atmosphère peut être formée d'un ou plusieurs gaz qui présente(nt), à la température et à la pression de ladite atmosphère, un coefficient de Joule-Thomson négatif. Autrement dit, ladite atmosphère ne comprend pas de gaz présentant, auxdites température et pression données, un coefficient de Joule-Thomson positif.

Par exemple, dans le cas de la réalisation du collage à température ambiante et pression atmosphérique, ladite atmosphère peut être formée d'un gaz ou mélange de gaz choisis(s) parmi l'hélium, le néon et l'hydrogène.

Selon un mode de réalisation particulier, ladite atmosphère est constituée d'hélium.

Selon une autre variante de réalisation, ladite atmosphère peut être formée d'un mélange (i) d'un ou plusieurs gaz présentant, à la température et pression de ladite atmosphère, un coefficient de Joule-Thomson négatif, et (ii) d'un ou plusieurs gaz présentant, à la température et pression de ladite atmosphère, un coefficient de Joule-Thomson positif.

Bien entendu, il appartient aux compétences de l'homme du métier d'ajuster les quantités respectives des différents gaz de manière à ce que le mélange final présente, à la température et à la pression de ladite atmosphère, un coefficient de Joule-Thomson négatif

Par exemple, dans le cas de la réalisation du collage à température ambiante et pression atmosphérique, ladite atmosphère peut être formée d'un mélange (i) d'un ou plusieurs gaz choisi(s) parmi l'hélium, le néon et l'hydrogène et (ii) d'un ou plusieurs gaz présentant, à température ambiante et pression atmosphérique, un coefficient de Joule-Thomson positif, en particulier choisi(s) parmi l'azote, l'oxygène et l'argon, dans des proportions telles que ledit mélange présente, à température ambiante et pression atmosphérique, un coefficient de Joule-Thomson négatif

En particulier, ladite atmosphère peut être formée d'un mélange (i) d'un ou plusieurs gaz choisi(s) parmi l'hélium, le néon et l'hydrogène avec (ii) de l'air, dans des proportions telles que ledit mélange présente, à température ambiante et pression atmosphérique, un coefficient de Joule-Thomson négatif

Selon un mode de réalisation particulier, ladite atmosphère est formée d'un mélange d'hélium et d'air dans des proportions telles que ledit mélange présente un coefficient de Joule-Thomson négatif

### PROCEDE DE COLLAGE

Le procédé de collage selon l'invention comprend les étapes classiquement mises en oeuvre pour le collage par adhésion moléculaire. Plus particulièrement, l'on procède tout d'abord à la mise en contact intime des surfaces des substrats à coller, puis le collage s'opère par propagation d'une onde de collage entre lesdits substrats.

### Substrats

Le procédé de l'invention est applicable à l'assemblage de tout type de matériau compatible avec le collage par adhésion moléculaire, et en particulier des matériaux isolants comme par exemple le quartz et le verre, et semi-conducteurs comme par exemple le silicium, le germanium, etc..

Le collage direct intervient en particulier dans le cadre de la réalisation de structures de type « semi-conducteur sur isolant », encore appelées SeOI (selon la terminologie anglo-saxonne « Semiconductor On Insulator »), et notamment pour la réalisation de structures de type « silicium sur isolant », encore appelées SOI (selon la terminologie anglo-saxonne « Silicon On Insulator »).

Dans le cadre de cette dernière application, l'un au moins des substrats à coller présente une couche d'oxyde en surface. A titre d'exemples, la formation d'une structure SOI peut comprendre un collage Si/SiO₂ ou encore SiO₂/SiO₂.

Les substrats à assembler peuvent être de formes diverses, pour autant qu'ils présentent chacun une surface plane appropriée à leur mise en contact intime.

Les substrats peuvent être plus particulièrement sous forme de tranches ou « wafer » au contour généralement circulaire et peuvent présenter différents diamètres, par exemple un diamètre allant de 100 nm à 300 nm.

### Préparation des surfaces

Les surfaces desdits substrats à coller peuvent être soumises, préalablement à leur mise en contact intime, à une ou plusieurs étapes de traitement de surface, en particulier destinée(s) à favoriser l'adhésion moléculaire, comme par exemple un polissage, nettoyage, traitement hydrophile/hydrophobe, etc..

Ces traitements peuvent être effectués sur l'une des deux surfaces à coller, voire sur les deux surfaces à coller.

En effet, pour favoriser l'adhésion moléculaire, les surfaces à coller doivent être suffisamment lisses, exemptes de particules ou de contamination.

A titre d'exemples de traitements chimiques, on peut notamment citer :
- le nettoyage de type RCA, à savoir la combinaison du bain SC₁ (NH₄OH, H₂O₂, H₂O) adapté au retrait des particules et des hydrocarbures et d'un bain SC₂ (HCl, H₂O₂, H₂O) adapté au retrait des contaminants métalliques ;
- le nettoyage avec une solution ozonée (O₃) adapté au retrait des contaminants organiques ; ou encore
- le nettoyage avec une solution contenant un mélange d'acide sulfurique et d'eau oxygénée (encore appelée solution SPM selon l'acronyme anglo-saxon de « sulfuric peroxide mixture »).

La préparation des surfaces à coller peut également comprendre une préparation mécanique des surfaces (léger polissage, brossage), en complément ou non des traitements chimiques. Ces traitements sont plus particulièrement destinés à procurer aux surfaces une planéité adaptée au collage. De préférence, la rugosité de surface, mesurée par exemple par microscopie à force atomique (c'est-à-dire avec des échelles latérales de longueur d'onde de 10 nm à 1 µm) n'excède pas, de préférence, 0,5 nm rms pour que le collage se fasse.

L'homme du métier est à même de mettre en oeuvre les méthodes adéquates de préparation des surfaces classiquement mises en oeuvre dans les techniques de collage par adhésion moléculaire.

Le procédé de l'invention peut également être associé à d'autres moyens connus, proposés pour réduire l'apparition de défauts, comme par exemple une modification de l'état de surface, de la souplesse des substrats, de la courbure des bords des substrats, etc..

### Etape (b) de collage

L'étape (b) de propagation de l'onde de collage selon le procédé de l'invention est opérée au sein d'une atmosphère de gaz spécifique telle que définie précédemment.

Comme évoqué précédemment, la propagation de l'onde de collage peut être avantageusement initiée par application d'au moins un point de pression sur au moins la surface exposée d'au moins l'un des deux substrats accolés.

Ce point de pression peut être appliqué sur le bord périphérique ou au centre dudit substrat, en particulier sur le bord périphérique. Le point de contact est initié typiquement par application d'une pression mécanique sur la surface exposée d'un des deux substrats au moyen d'un outil d'application (« doigt mécanique » ou encore « bond pin » en langue anglaise). L'application de cette force de contact permet d'initier la propagation d'une onde de collage à partir de ce point d'initiation. La propagation de l'onde de collage sur la totalité des surfaces de collage des substrats permet ainsi le collage par adhésion moléculaire des deux substrats.

L'intensité de la force de contact appliquée correspond généralement à une pression mécanique inférieure à 2 MPa.

Comme évoqué précédemment, le procédé de collage selon l'invention, en particulier mis en oeuvre à pression atmosphérique et température ambiante, a pour avantage d'être compatible avec les dispositifs couramment utilisés pour le collage par adhésion moléculaire.

Le procédé de l'invention peut ainsi être mis en oeuvre à l'aide de tout dispositif de collage classiquement utilisé pour le collage par adhésion moléculaire de deux substrats. De tels dispositifs comprennent, de manière générale, un porte-substrat et un outil d'application d'un point de pression pour initier l'onde de collage entre les deux substrats, par exemple un stylet en Téflon®.

Le dispositif classique de collage peut être introduit dans une enceinte contenant une atmosphère de gaz conforme à l'invention, en vue d'opérer le procédé de collage selon l'invention.

### APPLICATIONS

Selon un mode de réalisation particulier, le procédé de collage selon l'invention peut ainsi être mis en oeuvre dans un procédé de formation d'une structure de couche mince en un matériau semi-conducteur sur un substrat de réception, comme par exemple d'une structure SeOI et plus particulièrement d'une structure SOI.

Dans le cadre de la réalisation d'une telle structure, le procédé de collage est alors mis en oeuvre entre un substrat dit « substrat donneur » comportant une partie à transférer comprenant au moins une couche mince en un matériau semi-conducteur et présentant une première surface de collage, et un substrat dit « substrat de réception » présentant une seconde surface de collage.

Ainsi, la présente invention concerne également un procédé de formation d'une structure comportant une couche mince en un matériau semi-conducteur sur un substrat, comprenant au moins les étapes consistant en :
(c) disposer d'un substrat donneur comportant une partie à transférer comprenant au moins une couche mince dudit matériau semi-conducteur et présentant une première surface de collage, et d'un substrat de réception présentant la seconde surface de collage ;
(d) coller par adhésion moléculaire ladite première surface et ladite seconde surface ; et
(e) éliminer le reste du substrat donneur de ladite partie collée audit substrat de réception,
caractérisé en ce que l'étape (d) de collage par adhésion moléculaire est effectuée dans une atmosphère de gaz conforme à l'invention telle que décrite précédemment.

Ladite couche mince dudit matériau semi-conducteur peut comprendre au moins un matériau choisi parmi Si, SiC, SiGe, Ge, un composé III-V (semi-conducteurs composites fabriqués à partir d'un élément de la colonne III du tableau périodique des éléments et d'un élément de la colonne V), un composé II-VI, et leurs mélanges. Le substrat de réception peut comprendre une couche de matériau ou plusieurs couches d'un ou plusieurs matériaux présentant la deuxième surface de collage. Le support de réception peut comprendre un matériau choisi parmi le silicium, le saphir, le verre et le quartz.

La partie à transférer peut comprendre également, outre la couche mince à transférer, une autre couche de matériau présentant ladite première surface de collage. Cette autre couche peut comprendre en particulier au moins un matériau choisi parmi SiO₂, Si₃N₄, le diamant, Al₂O₃, AIN. Il peut s'agir notamment d'une couche de SiO₂.

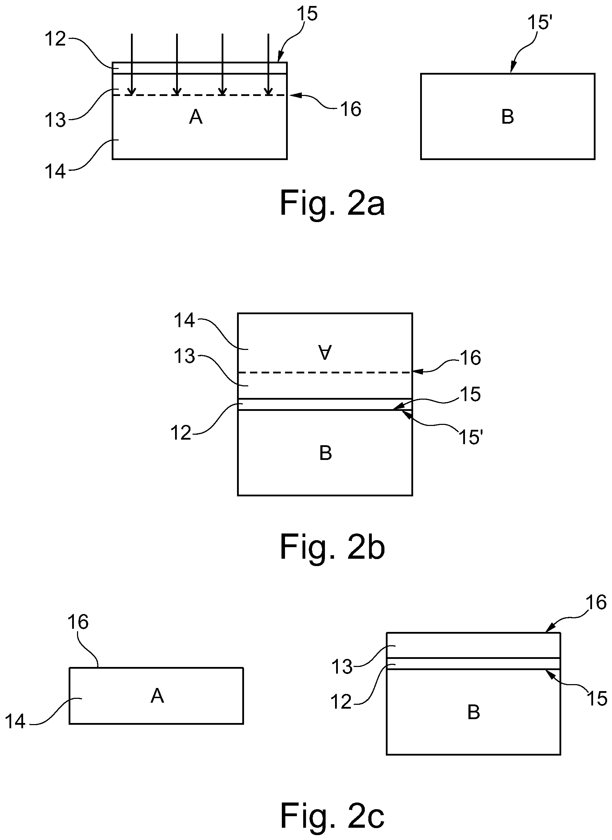

A titre d'exemple de réalisation, le procédé de collage selon l'invention peut être employé dans une technique de type Smart Cut® développée par la société Soitec, pour obtenir une structure empilée de type SOI. Cette technique est plus particulièrement décrite ci-après en référence à la figure 2.

Elle consiste à délimiter une couche mince en un matériau semi-conducteur avec un éventuel isolant dans un substrat initial (substrat donneur) par implantation ionique au travers d'une face de ce substrat pour obtenir une couche modifiée à une profondeur déterminée, puis à solidariser la face implantée avec une face d'un support de réception par collage direct, et enfin à séparer la couche mince du reste du substrat initial.

Plus particulièrement, la figure 2a montre un substrat (A) initial, par exemple en silicium, le cas échéant recouvert d'une couche (12) d'oxyde de silicium présentant une surface (15). Cette figure montre le substrat au cours d'une étape d'implantation ionique (figurée par des flèches) destinée à délimiter une couche mince (13) dans le substrat. Les espèces gazeuses implantées au travers de la surface (15) provoquent, après traitement thermique, à une profondeur déterminée par l'énergie d'implantation, une couche de microcavités (16). Les espèces gazeuses peuvent être choisies préférentiellement parmi l'hydrogène, l'hélium ou une combinaison de ces espèces. La couche mince (13) ainsi délimitée dans le substrat initial va ensuite être transférée sur un support de réception (B), par exemple en silicium.

La figure 2b montre la structure obtenue après collage selon l'invention par adhésion moléculaire de la surface (15) du substrat (A) et de l'une des surfaces (15') d'un substrat de réception (B).

Au cours d'une étape postérieure, la couche mince (13) est dissociée du reste du substrat initial par rupture au niveau de la couche (16). La fracture est par exemple obtenue au moyen d'un traitement thermique qui permet en outre de renforcer le collage direct. On obtient la structure empilée représentée à la figure 2c.

Cette structure comprend une couche mince de silicium (13) supportée par le support de réception (B) et isolée de ce support par une couche isolante constituée de la couche oxydée (12).

### FIGURES

Figure 1 : représentation graphique de la variation du coefficient de Joule-Thomson en fonction de la température pour différents gaz à pression atmosphérique.
Figure 2 : coupes transversales du ou des substrats aux différentes étapes du procédé Smart Cut®.

Il convient de noter que, pour des raisons de clarté, les différents éléments sur la figure 2 sont représentés en échelle libre, les dimensions réelles des différentes parties n'étant pas respectées.

L'exemple qui suit est donné à titre illustratif et non limitatif de l'invention.

### EXEMPLE

### Collage par adhésion moléculaire

Le collage par adhésion moléculaire a été opéré entre un premier wafer de silicium porteur d'une couche d'oxyde de silicium définissant une première surface de collage et un second wafer de silicium définissant une seconde surface de collage. Les wafers sont sous la forme de plaquettes circulaires de diamètre de 1 pouce (2,54 cm) à 450 mm.

Les surfaces à coller des substrats ont été préalablement nettoyées par brossage puis rinçage à l'eau ultra-pure et séchage par centrifugation.

Les substrats ont été disposés sur les porte-substrat d'un dispositif de collage classique (EV®540 Automated Wafer Bonding System de la société EVG), apte à amener les surfaces desdits substrats en contact intime et à initier l'onde de collage *via* l'application d'un doigt mécanique en un point du bord périphérique de la surface exposée de l'un des substrats.

Le dispositif de collage est introduit dans une enceinte contenant une atmosphère de gaz et dans laquelle s'effectue le collage automatisé par le dispositif de collage.

Le procédé de collage est répété en variant la nature de l'atmosphère de gaz de l'enceinte de collage, à température ambiante et pression atmosphérique. Les atmosphères testées sont les suivantes :
1. air,
2. azote,
3. argon, et
4. hélium.

### Résultats

L'observation de l'interface de collage, à l'aide d'une caméra infrarouge ou encore par microscopie acoustique, révèle la présence en bordure des plaques de défauts picots ou bulles dans le cas des plaques collées sous atmosphère d'air, d'azote ou d'argon.

En revanche, dans le cas du collage opéré sous atmosphère d'hélium, il n'est observé aucun défaut picot ou bulle à la périphérie de l'interface de collage.

## Revendications

1. Procédé de collage par adhésion moléculaire de deux substrats (A,B), comprenant au moins :
(a) la mise en contact intime des surfaces à coller desdits substrats (A,B); et
(b) la propagation d'une onde de collage entre lesdits substrats (A,B);
**caractérisé en ce que** lesdits substrats sont maintenus au cours de l'étape (b) dans une atmosphère de gaz présentant, à la température et à la pression de ladite atmosphère, un coefficient de Joule-Thomson négatif

2. Procédé selon la revendication 1, dans lequel la propagation de l'onde de collage est initiée par l'application d'au moins un point de pression sur au moins l'une des faces externes de l'ensemble formé par les deux substrats juxtaposés.

3. Procédé selon la revendication 1 ou 2, dans lequel ladite atmosphère est formée d'un gaz ou mélange de gaz, le ou lesdits gaz présentant, à la température et pression de ladite atmosphère, un coefficient de Joule-Thomson négatif

4. Procédé selon l'une quelconque des revendications précédentes, dans lequel ladite atmosphère est formée d'un mélange constitué (i) d'un ou plusieurs gaz présentant, à la température et à la pression de ladite atmosphère, un coefficient de Joule-Thomson négatif, et (ii) d'un ou plusieurs gaz présentant, à la température et à la pression de ladite atmosphère, un coefficient de Joule-Thomson positif, dans des proportions telles que ledit mélange présente, à la température et à la pression de ladite atmosphère, un coefficient de Joule-Thomson négatif

5. Procédé selon l'une quelconque des revendications précédentes, dans lequel l'étape (b) est réalisée à température ambiante et à pression atmosphérique.

6. Procédé selon la revendication 5, dans lequel ladite atmosphère comprend un ou plusieurs gaz choisi(s) parmi l'hélium, le néon et l'hydrogène.

7. Procédé selon la revendication 5 ou 6, dans lequel ladite atmosphère est formée d'un ou plusieurs gaz choisi(s) parmi l'hélium, le néon et l'hydrogène.

8. Procédé selon la revendication 5 ou 6, dans lequel ladite atmosphère est formée d'un mélange (i) d'un ou plusieurs gaz choisi(s) parmi l'hélium, le néon et l'hydrogène et (ii) d'un ou plusieurs gaz présentant, à température ambiante et pression atmosphérique, un coefficient de Joule-Thomson positif, en particulier choisi(s) parmi l'azote, l'oxygène et l'argon, dans des proportions telles que ledit mélange présente, à température ambiante et pression atmosphérique, un coefficient de Joule-Thomson négatif.

9. Procédé selon la revendication précédente, dans lequel ladite atmosphère est formée d'un mélange (i) d'un ou plusieurs gaz choisi(s) parmi l'hélium, le néon et l'hydrogène avec (ii) de l'air, dans des proportions telles que ledit mélange présente, à température ambiante et pression atmosphérique, un coefficient de Joule-Thomson négatif

10. Procédé selon l'une quelconque des revendications précédentes, dans lequel l'une des surfaces, voire les deux surfaces, à coller desdits substrats est/sont soumise(s), préalablement à l'étape (a), à une ou plusieurs étapes de traitement de surface, en particulier destinée(s) à favoriser l'adhésion moléculaire, telles qu'un polissage, nettoyage et/ou traitement hydrophile ou hydrophobe.

11. Procédé selon l'une quelconque des revendications 2 à 10, dans lequel le point de pression est appliqué sur le bord périphérique de la surface exposée d'au moins l'un des deux substrats juxtaposés.

12. Procédé de formation d'une structure comportant une couche mince (13) en un matériau semi-conducteur, en particulier en silicium, sur un substrat, comprenant au moins les étapes consistant en :
(c) disposer d'un substrat donneur (A) comportant une partie à transférer comprenant au moins une couche mince (13) dudit matériau semi-conducteur et présentant une première surface de collage (15), et d'un substrat de réception (B) présentant une seconde surface de collage (15') ;
(d) coller par adhésion moléculaire ladite première surface (15) et ladite seconde surface (15') ; et
(e) éliminer le reste du substrat donneur (A) de ladite partie collée audit substrat de réception (B),
**caractérisé en ce que** l'étape (d) de collage est effectuée selon le procédé tel que défini selon l'une quelconque des revendications 1 à 11.

13. Procédé selon la revendication précédente, dans lequel la partie à transférer comprend, outre ladite couche mince, une autre couche de matériau (12), en particulier d'oxyde de silicium, ladite autre couche de matériau (12) présentant ladite première surface de collage (15).

## Patentansprüche

1. Verfahren zur Klebung durch molekulare Adhäsion von zwei Substraten (A, B), zumindest umfassend:
(a) das in engen Kontakt Bringen der zu verklebenden Oberflächen der genannten Substrate (A, B); und
(b) die Ausbreitung einer Klebewelle zwischen den genannten Substraten (A, B); **dadurch gekennzeichnet, dass** die genannten Substrate während des Schrittes (b) unter einer Gasatmosphäre gehalten werden, die bei der Temperatur dem Druck dieser Atmosphäre einen negativen Joule-Thomson-Koeffizienten aufweist.

2. Verfahren nach Anspruch 1, bei dem die Ausbreitung der Klebewelle ausgelöst wird durch Ausübung mindestens eines Druckpunktes auf mindestens eine der äußeren Oberflächen des durch die beiden aneinander liegenden Substrate gebildeten Objekts.

3. Verfahren nach Anspruch 1 oder 2, bei dem die genannte Atmosphäre durch ein Gas oder Gasgemisch gebildet wird, bei dem das Gas oder die Gase bei der Temperatur und dem Druck der genannten Atmosphäre einen negativen Joule-Thomson-Koeffizienten haben.

4. Verfahren nach einem der vorstehenden Ansprüche, bei dem die genannte Atmosphäre gebildet wird durch ein Gemisch, das besteht aus (i) einem oder mehreren Gasen, die bei der Temperatur der genannten Atmosphäre einen negativen Joule-Thomson-Koeffizienten haben, und (ii) einem oder mehreren Gasen, die bei der Temperatur und dem Druck der genannten Atmosphäre einen positiven Joule-Thomson-Koeffizienten haben, in solchen Verhältnissen, dass das genannte Gemisch bei der Temperatur und dem Druck der genannten Atmosphäre einen negativen Joule-Thomson-Koeffizienten aufweist.

5. Verfahren nach einem der vorstehenden Ansprüche, bei dem der Schritt (b) bei Umgebungstemperatur und Atmosphärendruck ausgeführt wird.

6. Verfahren nach Anspruch 5, bei dem die genannte Atmosphäre ein oder mehrere Gase enthält, die ausgewählt sind unter Helium, Neon und Wasserstoff.

7. Verfahren nach Anspruch 5 oder 6, bei dem die genannte Atmosphäre durch ein oder mehrere Gase gebildet wird, die ausgewählt sind unter Helium, Neon und Wasserstoff.

8. Verfahren nach Anspruch 5 oder 6, bei die genannte Atmosphäre durch ein Gemisch gebildet wird aus (i) ein oder mehreren Gasen, die ausgewählt sind unter Helium, Neon und Wasserstoff, und (ii) ein oder mehreren Gasen, die bei Umgebungstemperatur und Atmosphärendruck einen positiven Joule-Thomson-Koeffizienten haben, insbesondere ausgewählt unter Stickstoff, Sauerstoff und Argon, in solchen Verhältnissen, dass das Gemisch bei der Umgebungstemperatur und dem Atmosphärendruck einen negativen Joule-Thomson-Koeffizienten hat.

9. Verfahren nach dem vorstehenden Anspruch, bei dem die genannte Atmosphäre durch ein Gemisch gebildet wird von (i) ein oder mehreren Gasen, die ausgewählt sind unter Helium, Neon und Wasserstoff, mit (ii) Luft, in solchen Verhältnissen, dass das genannte Gemisch bei Umgebungstemperatur und Atmosphärendruck einen negativen Joule-Thomson-Koeffizienten aufweist.

10. Verfahren nach einem der vorstehenden Ansprüche, bei dem eine oder beide der zu verklebenden Oberflächen der genannten Substrate vor dem Schritt (a) ein oder mehrere Schritten der Oberflächenbehandlung unterzogen wird/werden, insbesondere dazu bestimmt, die molekulare Adhäsion zu begünstigen, wie etwa Polieren, Reinigen, und/oder hydrophilisierende oder hydrophobisierende Behandlung.

11. Verfahren nach einem der Ansprüche 2 bis 10, bei dem der Druckpunkt auf dem Umfangsrand der freiliegenden Oberfläche mindestens eines der beiden aneinander liegenden Substrate ausgeübt wird.

12. Verfahren zur Bildung einer Struktur, die eine dünne Schicht (13) aus einem Halbleitermaterial aufweist, insbesondere aus Silizium, auf einem Substrat, welches Verfahren mindestens die Schritte aufweist, die bestehen in:
(c) Bereitstellen eines Donator-Substrats (A), das einen zu übertragenden Teil aufweist, der mindestens eine dünne Schicht (13) des genannten Halbleitermaterials aufweist und eine erste Klebfläche (15) bildet, und eines Akzeptor-Substrats (B), das eine zweite Klebfläche (15') bildet;
(d) Verkleben der genannten ersten Oberfläche (15) und der genannten zweiten Oberfläche (15') durch molekulare Adhäsion; und
(e) Entfernen des Rests des Donator-Substrats (A) von dem genannten Teil, der mit dem Akzeptor-Substrat (B) verklebt wurde,
**dadurch gekennzeichnet, dass** der Klebeschritt (d) nach dem Verfahren ausgeführt wird, das in einem der Ansprüche 1 bis 11 definiert wurde.

13. Verfahren nach dem vorstehenden Anspruch, bei den der zu übertragende Teil außer der genannten dünnen Schicht eine weitere Materialschicht (12) aufweist, insbesondere aus Siliziumoxid, wobei die genannte weitere Materialschicht (12) die genannte erste Klebfläche (15) bildet.

## Claims

1. Process for bonding two substrates (A,B) by molecular adhesion, comprising at least:
(a) bringing the surfaces to be bonded of the said substrates (A,B) into intimate contact; and
(b) propagating a bonding front between the said substrates (A,B);
**characterized in that** the said substrates are kept, during stage (b), in a gas atmosphere exhibiting, at the temperature and at the pressure of the said atmosphere, a negative Joule-Thomson coefficient.

2. Process according to Claim 1, in which the propagation of the bonding front is initiated by the application of at least one pressure point on at least one of the external faces of the assembly formed by the two juxtaposed substrates.

3. Process according to Claim 1 or 2, in which the said atmosphere is formed of a gas or gas mixture, the said gas or gases exhibiting, at the temperature and pressure of the said atmosphere, a negative Joule-Thomson coefficient.

4. Process according to any one of the preceding claims, in which the said atmosphere is formed of a mixture composed (i) of one or more gases exhibiting, at the temperature and at the pressure of the said atmosphere, a negative Joule-Thomson coefficient and (ii) of one or more gases exhibiting, at the temperature and at the pressure of the said atmosphere, a positive Joule-Thomson coefficient, in proportions such that the said mixture exhibits, at the temperature and at the pressure of the said atmosphere, a negative Joule-Thomson coefficient.

5. Process according to any one of the preceding claims, in which stage (b) is carried out at ambient temperature and at atmospheric pressure.

6. Process according to Claim 5, in which the said atmosphere comprises one or more gases chosen from helium, neon and hydrogen.

7. Process according to Claim 5 or 6, in which the said atmosphere is formed of one or more gases chosen from helium, neon and hydrogen.

8. Process according to Claim 5 or 6, in which the said atmosphere is formed of a mixture (i) of one or more gases chosen from helium, neon and hydrogen and (ii) of one or more gases exhibiting, at ambient temperature and atmospheric pressure, a positive Joule-Thomson coefficient, chosen in particular from nitrogen, oxygen and argon, in proportions such that the said mixture exhibits, at ambient temperature and atmospheric pressure, a negative Joule-Thomson coefficient.

9. Process according to the preceding claim, in which the said atmosphere is formed of a mixture (i) of one or more gases chosen from helium, neon and hydrogen with (ii) air, in proportions such that the said mixture exhibits, at ambient temperature and atmospheric pressure, a negative Joule-Thomson coefficient.

10. Process according to any one of the preceding claims, in which one of the surfaces, indeed even both surfaces, to be bonded of the said substrates is/are subjected, prior to stage (a), to one or more surface treatment stages intended in particular to promote molecular adhesion, such as a polishing, cleaning and/or hydrophilic or hydrophobic treatment.

11. Process according to any one of Claims 2 to 10, in which the pressure point is applied on the peripheral edge of the exposed surface of at least one of the two juxtaposed substrates.

12. Process for the formation of a structure comprising a thin layer (13) made of a semiconductor material, in particular made of silicon, on a substrate, comprising at least the stages consisting in:
(c) having available a donor substrate (A) comprising a part to be transferred comprising at least one thin layer (13) of the said semiconductor material and exhibiting a first bonding surface (15), and having available a receiving substrate (B) exhibiting a second bonding surface (15');
(d) bonding, by molecular adhesion, the said first surface (15) and the said second surface (15'); and
(e) removing the remainder of the donor substrate (A) from the said part bonded to the said receiving substrate (B),
**characterized in that** the bonding stage (d) is carried out according to the process as defined according to any one of Claims 1 to 11.

13. Process according to the preceding claim, in which the part to be transferred comprises, in addition to the said thin layer, another layer of material (12), in particular of silicon oxide, the said other layer of material (12) exhibiting the said first bonding surface (15).
